# EUROPÄISCHE PATENTSCHRIFT

(11) **EP 0 549 519 B1**
(45) Veröffentlichungstag und Bekanntmachung des Hinweises auf die Patenterteilung: **10.04.1996**
(21) Anmeldenummer: 92810840.6
(22) Anmeldetag: 03.11.1992
(51) Int. Cl.: E05B 45/06, E05B 17/22, G01F 15/00, G01R 11/24

(54) **Vorrichtung zur Registrierung einer Manipulation eines mechanischen Teils**
Device for registering the manipulation of a mechanical part
Dispositif pour l'enregistrement d'une manipulation d'une pièce mécanique

(30) Priorität: 15.11.1991 CH 3345/91
(43) Veröffentlichungstag der Anmeldung: 30.06.1993
(73) Patentinhaber: ZELLWEGER LUWA AG, CH-8610 Uster (CH)
(72) Erfinder: Dippong, Norbert, F-68700 Cernay (FR); Klein, Denis, F-68680 Kembs (FR)

(56) Entgegenhaltungen:
- EP-A- 0 006 147
- EP-A- 0 245 682
- EP-A- 0 315 335

## Beschreibung

Oft ist es erwünscht, Manipulationen an einem Gerät oder einer Einrichtung zur späteren Kontrolle registrieren zu können, insbesondere, wenn es sich dabei um unbefugte Manipulationen handelt. Dies kann zum Beispiel der Fall sein bei in Haushalten oder Industriebetrieben installierten Verbrauchszählern von Zulieferfirmen, wie etwa von Elektrizitäts-, Wasser- und Gaswerken oder auch Kabelfernsehgesellschaften und Fernwärmeversorger, wo es für den Lieferanten wichtig ist, zu wissen, ob vom Verbraucher eventuell versucht wurde, die korrekte Abrechnung durch geeignete Manipulation am Zähler zu umgehen.

Bisher besteht die üblicherweise eingesetzte Kontrollmethode im Anbringen einer Plombe, deren Unversehrtheit geprüft wird.

Da neuere Zähler jedoch mit elektronischer Messwertverarbeitung ausgerüstet sind und damit die Möglichkeit bieten, aus der Ferne abgelesen zu werden, wirkt sich die Verwendung einer Kontrollplombe nachteilig aus, denn diese lässt sich nur vor Ort prüfen. Es besteht deshalb das Bedürfnis nach einer Vorrichtung, die eine Manipulation an einem Zähler in einer Form registrieren kann, die fernablesbar ist.

Bei einer bekannten Ausführung eines Haushaltzählers ist aus diesem Grund ein spezielles Schlüsselteil im Gerät eingesetzt, welches beim Zudrehen der Plombierschraube einen Kontakt betätigt. Wird die Plombierschraube um mehr als 270° aufgedreht, so fällt dieses Schlüsselteil in das Geräteinnere, und ein Mikroprozessor, der den Kontakt periodisch überwacht, registriert den Vorgang und kann diesen bei einer nachfolgenden Ablesung signalisieren.

Eine andere Vorrichtung, mit der ein mechanischer Eingriff im Bereich eines Elektrizitätszählers feststellbar ist, offenbart die europäische Patentanmeldung EP-315 335. Hier wird zum Feststellen eines mechanischen Eingriffs ein Bauteil mit piezoelektrischen Eigenschaften verwendet. Dieses Bauteil wird so angeordnet, dass es durch den Eingriff deformiert wird und demzufolge ein elektrisches Signal erzeugt, mit dem eine Anzeigeeinrichtung ausgelöst wird. Bei der beschriebenen Ausführungsform der Vorrichtung ist der stromzuführende Leiter mit einem piezoelektrischen Mantel umgeben, so dass ein Versuch, an diesem Leiter eine Überbrückungsleitung zur Umgehung des Eletrizitätszählers anzubringen, eine Deformierung des piezoelektrischen Mantels und damit die Erzeugung eines elektrischen Signals zur Folge hat. Als Einrichtung zur Anzeige eines Eingriffs wird eine Gasentlandungslampe, ein Remanenzrelais, ein mittels eines Schreibkopfs beschreibbares Magnetband oder eine chemische Farbzelle eingesetzt. Dabei kann das vom piezoelelektrischen Bauteil erzeugte elektrische Signal zwar jeweils die Anzeige auslösen, jedoch wird für die Ansteuerung der Anzeigeeinrichtung zumindest zum Zeitpunkt des Eingriffs zusätzlich Hilfsenergie vom Netz benötigt. Weiter ist nicht ersichtlich, ob und wie sich mit der vorgeschlagenen Vorrichtung ein Eingriff am Zähler selbst, beziehungsweise an seinem Gehäuse, feststellen lässt.

Ein gewichtiger Nachteil bei diesen bekannten Vorrichtungen ist der Umstand, dass die Manipulation nur registriert werden kann, wenn das Gerät am Stromnetz angeschlossen ist. Durch Unterbrechen der Stromversorgung, beispielsweise durch Entfernen der Hauptsicherung und Öffnen des Gerätes im speisungslosen Zustand, lässt sich die Kontrollfunktion somit umgehen.

Eine Aufgabe der vorliegenden Erfindung ist es daher, eine Vorrichtung zur Registrierung einer Manipulation eines mechanischen Teils zu schaffen, die bei Bedarf fernablesbar ist und trotzdem auch ohne permanente Stromversorgung arbeiten kann. Zudem soll die Vorrichtung sich zur Ergänzung schon bestehender Geräte eignen und demgemäss konstruktiv möglichst einfach sowie ohne Einbezug von Spezialwerkzeugen oder speziellen Schlüsselteilen benutzbar sein.

Die Erfindung, mit welcher diese Aufgabe gelöst wird, ist im unabhängigen Patentanspruch 1 definiert, bevorzugte Ausführungsbeispiele ergeben sich aus den abhängigen Patentansprüchen. Demgemäss wird ein Piezoelement, welches mittels eines Verformmechanismus verformt wird, sobald das mechanische Teil manipuliert wird, dazu verwendet, im Manipulationsfall einen elektrischen Impuls zu erzeugen und mit diesem Impuls den Informationszustand eines nichtflüchtigen Speicherelements zu verändern, wodurch die Manpulation registriert wird.

Die Erfindung betrifft auch ein verschliessbares Gehaüse gemäß Anspruch 8 und einen Verbrauchszähler gemäß Anspruch 10.

Unter einem nichtflüchtigen Speicherelement soll ein Speicherelement verstanden werden, welches seine Information auch ohne Versorgungsspannung beibehält. Die Information muss dabei nicht zwingend in elektrischer Weise gespeichert sein, sondern könnte beispielsweise auch als Änderung einer magnetischen, optischen oder chemischen Eigenschaft vorliegen. Einzige Bedingung ist, dass die Information des Speicherelements durch einen elektrischen Impuls eines Piezoelements verändert werden kann.

Mit der erfindungsgemässen Vorrichtung werden gegenüber dem Stand der Technik einige beachtenswerte Vorteile erreicht. Die Kombination eines nichtflüchtigen Speicherelements mit einem Piezoelement, welches bei einer Manipulation des mechanischen Teils einen elektrischen Impuls liefert, macht die Vorrichtung unabhängig von einer externen Stromversorgung und führt zu einer sehr zuverlässigen Registrierung von Manipulationen. Da sowohl die notwendige elektrische Schaltung als auch der Mechanismus zur Auslösung einer Verformung des Piezoelements einfach zu realisieren ist, lässt sich die Vorrichtung gut als Zusatz in beliebigen Geräten integrieren. Zudem ist sie auf kleinem Raum zu verwirklichen und kostengünstig herzustellen.

Falls das Speicherelement während dem Verändern seines Informationsinhalts eine Versorgungsspannung benötigt, kann das Piezoelement zusätzlich auch mit einem Versorgungsspannungsanschluss des Speicherelements verbunden sein, um die gewünschte Unabhängigkeit von einer externen Speisung zu erreichen.

In einer vorteilhaften Ausführungsform ist das Speicherelement mit einer externen Datenübertragungsleitung verbunden, über die das Speicherelement fernablesbar und fernrücksetzbar ist. Damit lässt sich aus Distanz, im Falle von Verbrauchszählern beispielsweise direkt vom Lieferwerk aus, überprüfen, ob das Teil manipuliert wurde, womit ein Besuch einer Kontrollperson vor Ort unnötig wird. Weiter ist es möglich, in Verbindung mit dem Speicherelement einen Mikroprozessor vorzusehen, der die Auslese- und Steuer-funktionen übernimmt. Kommt die erfindungsgemässe Vorrichtung in einem Gerät zum Einsatz, welches selbst schon mit einem Mikroprozessor arbeitet, so kann dieser gleichzeitig zur Ansteuerung des Speicherelements verwendet werden. Ebenso lässt sich eine eventuell schon vorhandene Datenübertragungsleitung gleichzeitig zur Fernablesung des Speicherelements einsetzen.

Als nichtflüchtiges Speicherelement eignet sich zweckmässig ein EAROM (electrically alterable read only memory) beziehungsweise EEPROM (electrically erasable programmable read only memory). Derartige Speicherelemente können gegebenenfalls zusammen mit weiteren elektronischen Schaltkreisen in einer sogenannten anwendungsspezifischen integrierten Schaltung (ASIC, application specific integrated circuit) gefertigt werden, was erlaubt, eine für den Betrieb der erfindungsgemässen Vorrichtung benötigte elektronische Schaltung zusammen mit dem Speicherelement in einem einzigen Bauteil zu vereinen, und dieses in vergleichsweise kostengünstiger Weise zu produzieren.

Wird die Erfindung im Innern eines verschliessbaren Gehäuses so angeordnet, dass sich das Gehäuse nur öffnen lässt, indem ein als mechanisches Teil der erfindungsgemässen Vorrichtung fungierendes Teil bewegt bzw. manipuliert wird, so kann jedes Öffnen dieses Gehäuses registriert werden. Dabei kommen für das mechanische Teil zur Auslösung des Verformmechanismus etwa zu bewegende Verschlussteile oder mit diesen verbundene Teile in Frage, aber auch die zu entfernende Abdeckung selbst oder irgendein sonstiges Teil, das geeignet mit dem Öffnungsvorgang gekoppelt ist.

Ein Ausführungsbeispiel der Erfindung wird nachstehend anhand der beiliegenden Zeichnungen beschrieben. Dabei zeigen:
Fig. 1a bis 1d einen durch Bewegen eines mechanischen Teils auslösbaren Verformmechanismus,
Fig. 2 das Schema einer elektronischen Schaltung zur Verbindung von Piezoelement und Speicherelement und
Fig. 3a und 3b die Anordnung einer erfindungsgemässen Vorrichtung zur Kontrolle eines Gehäuse-Verschlusses.

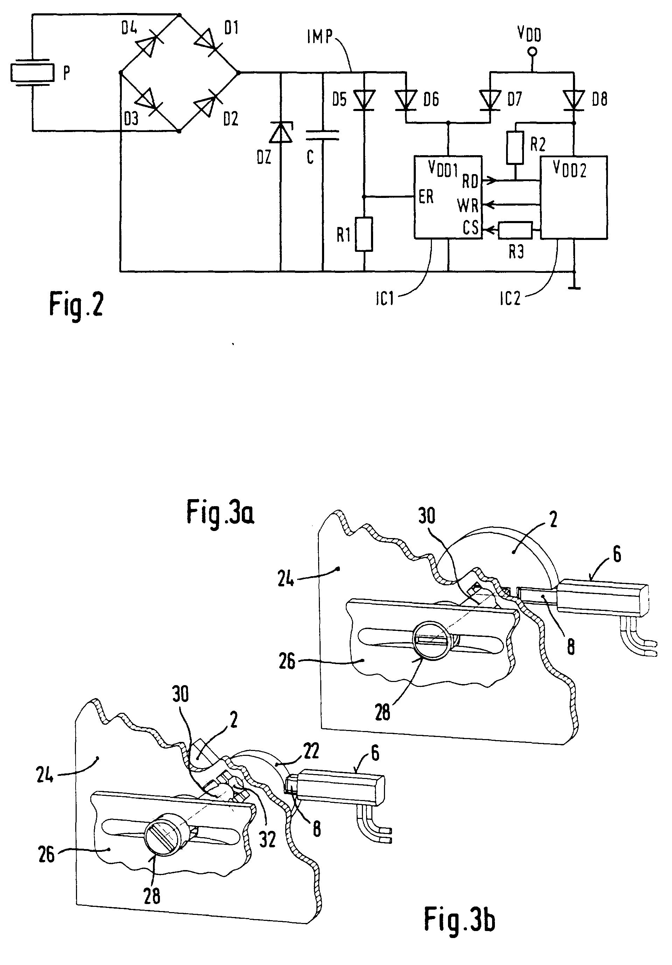

Die Figuren 1a bis 1d illustrieren ein Ausführungsbeispiel eines Verformmechanismus, der durch eine Bewegung eines mechanischen Teils 2 dazu gebracht wird, ein Piezoelement P zu verformen. Das mechanische Teil ist im vorliegenden Fall eine Scheibe, die in einer Achse 4 drehbar gelagert ist. Die Scheibe 2 könnte beispielsweise mit der Drehachse eines Gehäuseverschlusses gekoppelt sein (vgl. Fig. 3a, 3b). Der Verformmechanismus befindet sich in einem (nur teilweise gezeichneten) Gehäuseblock 6, in welchem auch das Piezoelement P gehalten ist. Er umfasst ein Auslöseglied in Form eines Schiebers 8, ein am Schieber 8 in der Achse 10 schwenkbar gelagertes Hammerglied 12, ein mit seinem einen Ende am Gehäuseblock 6 und mit seinem anderen Ende am Hammerglied 12 angebrachtes Federelement 14 sowie eine am Gehäuseblock 6 in der Achse 16 schwenkbar gelagerte Klinke 18. Ein Zapfen 20 am Hammerglied 12 wirkt mit der Klinke 18 zusammen. Der Schieber 8 ist in Richtung seiner Längsachse 12 verschiebbar gelagert.

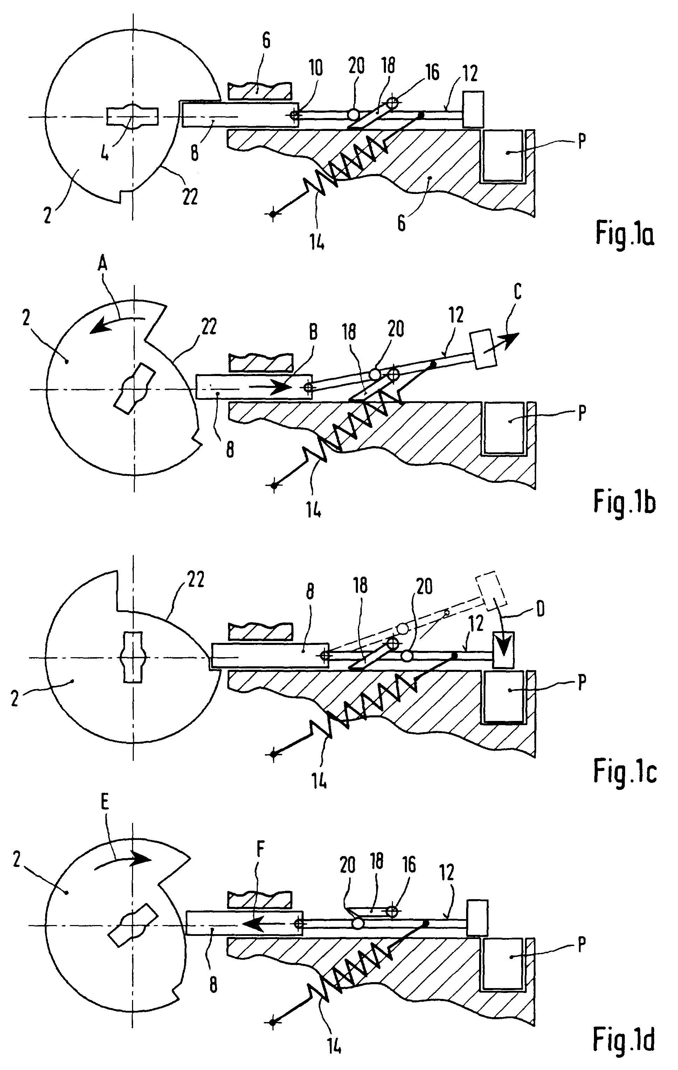

Aus den drei in den Figuren 1a, 1b und 1c dargestellten Ablaufphasen ist erkennbar, wie eine Drehung der Scheibe 2 zu einer Verformung des Piezoelements P führt. Die Scheibe 2 weist eine Fläche 22 auf, die als Steuerfläche für eine Verschiebung des Schiebers 8 in Abhängigkeit der Drehstellung der Scheibe 2 ausgebildet ist. Der Schieber 8 wird über das Hammerglied 12 vom Federelement 14 gegen die Steuerfläche 22 gedrückt. In der Ausgangsstellung (Fig. 1a) ist der Schieber 8 am weitesten vom Piezoelement P entfernt und der Zapfen 20 am Hammerglied 12 liegt auf der Klinke 18 auf. Wird die Scheibe 2 in Richtung des Pfeils A gedreht (Fig. 1b), so stösst die Steuerfläche 22 den Schieber 8 in Richtung Piezoelement P (Pfeil B). Dadurch wird der Zapfen 20 auf der Klinke 18 nach oben geschoben und das Hammerglied 12 hochgehoben (Pfeil C). Durch noch weiteres Drehen (Fig. 1c) der Scheibe 2 wird der Zapfen 20 über das Ende der Klinke 18 hinausgeschoben, sodass das Hammerglied 12 nicht mehr gestützt ist und durch die Zugwirkung des Federelements 14 auf das Piezoelement P schlägt (Pfeil D) und dieses verformt. In Figur 1d ist gezeigt, wie im Anschluss an einen durch das Drehen der Scheibe 2 ausgelösten Verformvorgang die Ausgangsstellung wieder erreicht wird. Nach dem Schlag liegt der Zapfen 20 unterhalb der Klinke 18. Wird nun die Scheibe 2 zurückgedreht (Pfeil E), so werden der Schieber 8 und das Hammerglied 12 gegen die Scheibe 22 verschoben (Pfeil F), wobei der Zapfen 20 unter der von ihm hochgehobenen Klinke 18 hindurchläuft, bis die Klinke wieder nach unten fallen kann und der Verformmechanismus in der Ausgangsstellung steht.

Das Piezoelement P ist mit (in den Figuren 1a bis 1d nicht abgebildeten) elektrischen Leitern mit einem nichtflüchtigen Speicherelement verbunden, über die der im Moment der Verformung des Piezoelements erzeugte elektrische Impuls zu einer Informationsänderung im Speicherelement eingesetzt werden kann.

Eine mögliche Auslegung einer elektronischen Schaltung zur Verbindung eines Piezoelements P mit einem nichtflüchtigen Speicherelement IC1 zeigt Figur 2. Der elektrische Impuls wird vom Piezoelement P über einen Gleichrichter (Dioden D1,D2,D3,D4) zum Speicherelement IC1 geleitet (Leiter IMP). Das Piezoelement P kann beispielsweise vom Typ sein, wie er in Gasanzündern verwendet wird; derartige Piezoelemente sind, je nach Ausführung, zum Beispiel in der Lage, bei Verformung 0,6 mJ Energie zu liefern, und müssen dazu etwa mit 1,7 kg belastet werden. Das Speicherelement IC1 ist ein EAROM, von dessen Ein- und Ausgängen nur die im vorliegenden Zusammenhang relevanten eingezeichnet sind, nämlich ein Versorgungsspannungsanschluss V_{DD1}, ein Löscheingang ER (Erase), ein Leseausgang RD (Read), ein Schreibeingang WR (Write) und ein Auswahleingang CS (Chip Select).

Parallel zum EAROM (IC1) ist eine Zenerdiode DZ und ein Kondensator C geschaltet. Die Zenerdiode dient zur Spannungsbegrenzung und der Kondensator zur Zwischenspeicherung der vom Piezoelement gelieferten Energie. Der Löscheingang ER des EAROM ist über eine Diode D5 mit dem Leiter IMP verbunden.

In der hier gewählten Schaltungsanordnung wird die EAROM-Speicherzelle durch den elektrischen Impuls des Piezoelements gelöscht (rückgesetzt). Dies ist deshalb vorteilhaft, weil derartige Speicherelemente zum Löschen weniger Energie benötigen als zum Setzen. Es wäre jedoch prinzipiell genauso möglich, das EAROM umgekehrt zu betreiben, also mit dem Impuls des Piezoelements zu setzen.

Damit ein Löschen auch ohne Vorliegen einer externen Stromversorgung möglich ist, ist der Leiter IMP weiter über eine Diode D6 mit dem Versorgungsspannungsanschluss V_{DD1} des EAROM verbunden, sodass mit dem elektrischen Impuls des Piezoelements während des Löschvorgangs gleichzeitig die nur kurzfristig benötigte Speisung des EAROM erzeugt werden kann.

Dem EAROM kann, wie in der Figur zu sehen, ein Mikroprozessor IC2 beigeordnet sein, der das EAROM ansteuert, es beispielsweise periodisch ausliest und auf eine Änderung im Informationszustand hin überprüft. Ist das EAROM gelöscht, so registriert der Mikroprozessor die damit festgestellte Manipulation in einem Zähler, welcher auch als sogenanntes Fraude-Register bezeichnet wird, und setzt das EAROM neu. Zur Fernablesung des Fraude-Registers lässt sich der Mikroprozessor in irgendeiner dem Fachmann bekannten Weise an eine Datenübertragungsleitung anschliessen.

Die Stromversorgung des Mikroprozessors erfolgt über den Anschluss V_{DD}. Dieser Anschluss ist gleichzeitig über eine Diode D7 mit dem Versorgungsspannungsanschluss V_{DD1} des EAROM verbunden, sodass dieses entweder von der Stromversorgung oder vom Piezoelement gespeist werden kann. Damit Leckströme, die eventuell vom Stromversorgungsanschluss V_{DD} via die Diode D6 auf die Seite des Löscheingangs ER eindringen, abgeleitet werden können, ist der Löscheingang über einen Widerstand R1 mit Masse verbunden. Zum symmetrischen Ausgleich der Versorgungsspannung von EAROM und Mikroprozessor ist zwischen dem Versorgungsspannungsanschluss V_{DD2} des Mikroprozessors und dem Anschluss V_{DD} ebenfalls eine Diode, D8, eingefügt.

Die erfindungsgemässe Vorrichtung kann zweckmässig zur Kontrolle des Verschlusses eines Gehäuses, insbesondere eines Verbrauchszähler-Gehäuses, eingesetzt werden. Die Figuren 3a und 3b zeigen einen Ausschnitt eines solchen Gehäuses mit einer Gehäusewand 24, einem Verschlussdeckel 26 und einem Bajonettverschluss 28. Teile, die der in den Figuren 1a bis 1d dargestellten Anordnung entsprechen, sind mit den dort verwendeten Bezugszeichen bezeichnet. Im Innern des Gehäuses befindet sich die drehbar gelagerte Scheibe 2 und der Gehäuseblock 6 mit dem Verformmechanismus und dem Piezoelement P. Der als Auslöseglied dienende Schieber 8 liegt an der Steuerfläche 22 der Scheibe 2 an.

Bei geschlossenem Gehäuse (Fig. 3a) greift die Drehachse 30 des Bajonettverschlusses 28 formschlüssig in eine entsprechende Bohrung 32 im Zentrum der Scheibe 2 und die Scheibe 2 steht in einer der Figur 1a oder 1d entsprechenden Position. Bevor das Gehäuse geöffnet werden kann, muss der Bajonettverschluss 28 gedreht werden (Fig. 3b). Damit wird aber auch die Scheibe 2 gedreht und zwar in eine der Figur 1c entsprechende Position, womit eine Verformung des Piezoelement ausgelöst und die Öffnung des Gehäuses im Speicherelement registriert wird.

Abschliessend sei ausdrücklich erwähnt, dass die dargestellten und beschriebenen Ausführungsformen lediglich Beispiele darstellen, die vom Fachmann im Rahmen des im unabhängigen Patentanspruch definierten Erfindungsgedankens in mannigfaltiger Weise abgewandelt werden können. So wäre es beispielsweise möglich, als Speicherelement anstelle des EAROM unter anderem ein Ringkern-Speicherelement oder auch einen Magnetblasenspeicher vorzusehen. Auch der Verformmechanismus lässt sich vom Fachmann in vielfältiger Weise ausbilden, unter anderem etwa in der Art von bekannten Schlagbolzen- oder Kippschalter-Antrieben. Weiter ist die Vorrichtung nicht nur für die Kontrolle verschliessbare Gehäuse einsetzbar, sondern für jeden Anwendungsfall, bei dem die Manipulation eines mechanischen Teils kontrolliert werden muss. Hier wäre zum Beispiel auch die Überwachung von Hebel- oder Schalterstellungen denkbar. Und selbstverständlich kann die zu registrierende Manipulation anstelle einer Drehung auch eine Verlagerung des mechanischen Teils sein. So liesse sich beispielsweise der Schieber 8 des in Figur 1 gezeigten Verformmechanismus als das mechanische Teil auffassen, dessen Manipulation, in diesem Fall Verschiebung, registriert werden soll.

## Patentansprüche

1. Vorrichtung zur Registrierung einer Manipulation eines mechanischen Teils (2), die ein Piezoelement (P) und ein elektrisch beschreibbares, nichtflüchtiges Speicherelement (IC1) aufweist, wobei das Piezoelement (P) mit einem Informationsänderungseingang (ER) des Speicherelements (IC1) elektrisch verbunden ist, *gekennzeichnet* durch, einen auf das Piezoelement (P) wirkenden Verformmechanismus (8,12,14,18, 20), der durch eine Bewegung des mechanischen Teils (2) auslösbar ist, derart, dass bei Bewegung des mechanischen Teils (2) ein vom Piezoelement (P) ausgehender elektrischer Impuls erzeugbar ist, mit dem der Informationszustand einer Informationseinheit im Speicherelement (IC1) veränderbar ist.

2. Vorrichtung nach Patentanspruch 1, dadurch *gekennzeichnet,* dass das Piezoelement (P) mit dem Informationsänderungseingang (ER) des Speicherelements (IC1) über eine Gleichrichterschaltung (D1,D2,D3,D4) und eine Filterschaltung (DZ,C) zur Anpassung an vorgegebene Spezifikationen des Speicherelements elektrisch verbunden ist.

3. Vorrichtung nach einem der Patentansprüche 1 oder 2, dadurch *gekennzeichnet,* dass das Piezoelement (P) zusätzlich mit einem Versorgungsspannungsanschluss (V_{DD1}) des Speicherelements (IC1) elektrisch verbunden ist, so dass mit dem durch das Piezoelement (P) erzeugbaren elektrischen Impuls sowohl der Informationszustand einer Informationseinheit veränderbar, als auch eine dabei benötigte Versorgungsspannung anlegbar ist.

4. Vorrichtung nach einem der Patentansprüche 1 bis 3, dadurch *gekennzeichnet*, dass das Speicherelement (IC1), gegebenenfalls über zusätzliche Schaltelemente (IC2), mit einer Datenübertragungsleitung verbindbar ist, über die das Speicherelement fernablesbar und/oder fernrücksetzbar ist.

5. Vorrichtung nach einem der Patentansprüche 1 bis 4, dadurch *gekennzeichnet*, dass das Speicherelement (IC1) elektrisch mit einem Mikroprozessor (IC2) verbunden ist, der das Speicherelement (IC1) ansteuern, also beipielsweise die Informationszustände des Speicherelements auslesen, zwischenspeichern sowie rücksetzen kann.

6. Vorrichtung nach einem der Patentansprüche 1 bis 5, dadurch *gekennzeichnet*, dass das Speicherelement (IC1) ein EAROM oder eine EAROM-Zelle ist.

7. Vorrichtung nach einem der Patentansprüche 1 bis 6, dadurch *gekennzeichnet*, dass das mechanische Teil (2) drehbar gelagert ist und eine Steuerfläche (22) aufweist, welche in einem Bereich an einem Auslöseglied (8) des Verformmechanismus (8,12,14,18,20) anliegt und so verläuft, dass durch Drehen des mechanischen Teils (2) das Auslöseglied (8) von einer Ruhestellung in eine Auslösestellung bringbar ist.

8. Verschliessbares Gehäuse (24,26) mit einer Vorrichtung nach einem der Patentansprüche 1 bis 7, dadurch *gekennzeichnet*, dass diese im Innern des Gehäuses (24,26) derart angeordnet ist, dass beim Öffnen des Gehäuses (24,26) das mechanische Teil (2) zwingend zu bewegen und damit der Verformmechanismus (8,12,14,18,20) zwingend auslösbar ist.

9. Verschliessbares Gehäuse (24,26) mit einer Vorrichtung nach Patentanspruch 7, dadurch *gekennzeichnet*, dass diese im Innern des Gehäuses (24,26) angeordnet ist und das eine Steuerfläche (22) aufweisende, drehbar gelagerte mechanische Teil (2) zumindest bei geschlossenem Gehäuse mit einer Drehachse (30) eines Verschlusses (28), mit dem das Gehäuse verschliessbar ist, derart in Eingriff steht, dass beim Öffnen des Verschlusses (28) das mechanische Teil (2) zwingend so zu drehen ist, dass das Auslöseglied (8) in eine Auslösestellung gelangt.

10. Verbrauchszähler mit einem verschliessbaren Gehäuse nach einem der Patentansprüche 8 oder 9.

## Claims

1. Device for registering a manipulation of a mechanical part (2), which device has a piezo element (P) and a nonvolatile memory element (IC1) which can be written on electrically, the piezo element (P) being electrically connected to an information modifying input (ER) of the memory element (IC1), characterized by a deformation mechanism (8, 12, 14, 18, 20) which acts on the piezo element (P) and can be triggered by a movement of the mechanical part (2) such that, when the mechanical part (2) moves, an electrical pulse which starts from the piezo element (P) can be generated, with which electrical pulse the information status of an information unit in the memory element (IC1) can be modified.

2. Device according to Patent Claim 1, characterized in that the piezo element (P) is electrically connected to the information modifying input (ER) of the memory element (IC1) via a rectifier circuit (D1, D2, D3, D4) and a filter circuit (DZ, C) in order to adapt it to prescribed specifications of the memory element.

3. Device according to one of Patent Claims 1 or 2, characterized in that the piezo element (P) is additionally electrically connected to a supply voltage terminal (V_{DD1}) of the memory element (IC1) so that the electrical pulse which can be generated by means of the piezo element (P) can be used both to modify the information status of an information unit and to apply a supply voltage which is required during this process.

4. Device according to one of Patent Claims 1 to 3, characterized in that the memory element (IC1) can be connected, if desired via additional switching elements (IC2), to a data transmission line via which the memory element can be read remotely and/or reset remotely.

5. Device according to one of Patent Claims 1 to 4, characterized in that the memory element (IC1) is electrically connected to a microprocessor (IC2) which can drive the memory element (IC1), that is to say read, buffer and rest for example the information statuses of the memory element.

6. Device according to one of Patent Claims 1 to 5, characterized in that the memory element (IC1) is an EAROM or an EAROM cell.

7. Device according to one of Patent Claims 1 to 6, characterized in that the mechanical part (2) is rotatably mounted and has a control face (22) which in one region bears against a triggering element (8) of the deformation mechanism (8, 12, 14, 18, 20) and proceeds in such a way that by rotating the mechanical part (2) the triggering element (8) can be moved from a position of rest into a triggering position.

8. Lockable housing (24, 26) with a device according to one of Patent Claims 1 to 7, characterized in that the said device is arranged in the interior of the housing (24, 26) in such a way that when the housing (24, 26) is opened the mechanical part (2) can be forcibly moved and thus the deformation mechanism (8, 12, 14, 18, 20) can be forcibly triggered.

9. Lockable housing (24, 26) having a device according to Patent Claim 7, characterized in that the said device is arranged in the interior of the housing (24, 26) and the mechanical part (2) which has a control face (22) and is rotatably mounted is in engagement, at least when the housing is closed, with a rotational axis (30) of a closure (28) with which the housing can be locked, such that when the closure (28) is opened the mechanical part (2) can be rotated forcibly in such a way that the triggering element (8) moves into a triggering position.

10. Consumption meter with a lockable housing according to one of Patent Claims 8 or 9.

## Revendications

1. Dispositif pour l'enregistrement d'une manipulation d'une pièce mécanique (2), qui comprend un élément piézo-électrique (P) et un élément de mémorisation (IC1) non volatile et susceptible d'inscriptions électriques, l'élément piézo-électrique (P) étant relié électriquement à une entrée de modification d'informations (ER) de l'élément de stockage (IC1), caractérisé par un mécanisme de déformation (8, 12, 14, 18) agissant sur l'élément piézo-électrique (P) et qui peut être déclenché par un mouvement de la pièce mécanique (2) de façon que lors du mouvement de la pièce mécanique (2) une impulsion électrique soit produite qui provient de l'élément piézo-électrique (P) et à l'aide de laquelle l'état d'information d'une unité d'information dans l'élément de stockage (IC1) peut être changé.

2. Dispositif selon la revendication 1, caractérisé en ce que le piézo-élément (P) est relié électriquement à l'entrée de modification d'information (ER) de l'élément de stockage (IC1) par l'intermédiaire d'un montage redresseur (D1, D2, D3, D4) et d'un circuit filtre (DZ, C) pour l'adaptation à des spécifications prédéterminées de l'élément de stockage.

3. Dispositif selon l'une des revendications 1 ou 2, caractérisé en ce que le piézo-élément (P) est relié électriquement supplémentairement à une borne de tension d'alimentation (V_{DD1}) de l'élément de stockage (IC1), de façon qu'à l'aide de l'impulsion électrique pouvant être produite par le piézo-élément (P) l'état d'information d'une unité d'information puisse être varié et une tension d'alimentation nécessaire à cette fin puisse être appliquée.

4. Dispositif selon l'une des revendications 1 à 3, caractérisé en ce que l'élément de stockage peut être relié, le cas échéant, par l'intermédiaire d'éléments commutateurs supplémentaires (IC2) à une ligne de transmission de données par l'intermédiaire de laquelle l'élément de stockage peut être lu et/ou remis à distance.

5. Dispositif selon l'une des revendications 1 à 4, caractérisé en ce que l'élément de stockage (IC1) est relié électriquement à un microprocesseur (IC2) qui commande l'élément de stockage (IC1), c'est-à-dire peut par exemple lire stocker transitoirement et remmettre à l'état initial les états d'information de l'élément de stockage.

6. Dispositif selon l'une des revendications 1 à 5, caractérisé en ce que l'élément de stockage (IC1) est une EAROM ou une cellule de EAROM.

7. Dispositif selon l'une des revendications 1 à 6, caractérisé en ce que la pièce mécanique (2) est montée rotative et comprend une surface de commande (22) qui est appliquée dans une zone à un organe de déclenchement (8) du mécanisme de déformation et s'étend de façon que, par rotation de la pièce mécanique (2), l'organe de déclenchement (8) puisse être amené de sa position de repos en une position de déclenchement.

8. Boîtier susceptible d'être fermé (24, 26) avec un dispositif selon l'une des revendications 1 à 7, caractérisé en ce que celui-ci est disposée à l'intérieur du boîtier (24, 26) de façon que lors de l'ouverture du boîtier (24, 26) la pièce mécanique (2) est forcée de se déplacer et ainsi le mécanisme de déformation (8, 12, 14, 18, 20) est susceptible d'être obligatoirement déclenché.

9. Boîtier susceptible d'être fermé (24, 26) avec un dispositif selon la revendication 7, caractérisé en ce que celui-ci est disposé à l'intérieur du boîtier (24, 26) et que la pièce mécanique comportant une surface de commande (22) est montée rotative est en engagement, lorsque le boîtier est fermé, avec un axe de rotation (30) d'une fermeture (28) pour la fermeture du boîtier, de façon que, lors de l'ouverture de la fermeture (28) la pièce mécanique (2) soit obligatoirement entraînée en rotation de façon que l'organe de déclenchement (8) parvienne dans une position de déclenchement.

10. Compteur de consommation avec un boîtier susceptible d'être fermé selon l'une des revendications 8 ou 9.
